# FASCICULE DE BREVET EUROPEEN

(11) **EP 1 521 364 B1**
(45) Date de publication et mention de la délivrance du brevet: **21.08.2013**
(21) Numéro de dépôt: 03021920.8
(22) Date de dépôt: 29.09.2003
(51) Int. Cl.: H03K 5/1254, G01R 19/165

(54) **Procédé et dispositif pour le filtrage de signaux produits par un accéléromètre de type piézo-électrique, et application à un objet portatif tel qu'une montre**
Verfahren und Vorrichtung zur Filterung von durch einen Piezoelektrischen Beschleunigungsmesser erzeugten Signalen, und Anwendung auf einem tragbaren Gegenstand wie zum Beispiel eine Uhr
Method and apparatus for filtering signals generated by a piezoelectric accelerometer, and application in a portable object such as a watch

(43) Date de publication de la demande: 06.04.2005
(73) Titulaire: EM Microelectronic-Marin SA, 2074 Marin (CH)
(72) Inventeur: Galli, Reto, 3012 Bern (CH); Peguiron, Mathias, 2000 Neuchatel (CH); Godat, Yves, 2087 Cornaux (CH); Jeannet, Nicolas, 2202 Chambrelien (CH)
(74) Mandataire: Ravenel, Thierry Gérard Louis

(56) Documents cités:
- EP-A- 0 280 254
- EP-A- 1 187 330
- US-A- 3 961 271
- US-A- 5 197 489
- US-A- 5 760 691
- US-B1- 6 353 579

## Description

La présente invention concerne un procédé de filtrage des signaux électriques produits par un accéléromètre de type piézo-électrique en réponse à un choc mécanique. La présente invention concerne également un dispositif pour la mise en oeuvre d'un tel procédé. La présente invention concerne enfin l'application d'un tel dispositif à un objet portatif tel qu'une montre.

On connaît par le brevet américain US 5,760,691 délivré le 2 juin 1998 au nom de la société Scubapro un instrument de plongée comprenant un dispositif d'affichage à cristaux liquides logé de façon étanche dans un boîtier transparent. L'instrument de plongée comprend également un accéléromètre capable de détecter un choc appliqué sur le boîtier. En réponse à la détection d'un choc, l'accéléromètre produit un signal qui commande l'allumage d'un dispositif de rétro-éclairage de la cellule à cristaux liquides.

L'invention Scubapro permet de s'affranchir de l'utilisation d'un bouton-poussoir pour commander l'éclairage du dispositif d'affichage à cristaux liquides, ce qui s'avère particulièrement avantageux dans le cas d'un instrument de plongée. En effet, les plongeurs portent fréquemment aux mains des gants épais qui leur rendraient la manipulation d'un bouton-poussoir malaisée.

Il faut cependant s'assurer que l'éclairage du dispositif d'affichage ne s'allume pas de manière intempestive en réponse à un choc involontaire, car cela affecterait la durée de vie de la source d'énergie, typiquement une pile au lithium, qui alimente en courant l'instrument de plongée. Pour remédier à ce problème, Scubapro propose d'utiliser un filtre passe-bande dont le rôle est de filtrer les signaux caractéristiques produits par l'accéléromètre en réponse à un choc appliqué sur le boîtier. Le filtre doit permettre d'éviter que les signaux électriques provenant de l'accéléromètre et correspondant, par exemple, à des bruits d'abrasion, ne provoquent l'allumage des moyens d'éclairage de la cellule d'affichage. A cet effet, Scubapro a déterminé que la fréquence des signaux produits par l'accéléromètre en réponse à un choc volontaire appliqué sur le boîtier à l'aide d'un doigt était comprise dans un intervalle s'étendant de 6 à 25 kHz. C'est pour cette raison que la fréquence de coupure haute du filtre passe-bande a été fixée à 25 kHz, et que sa fréquence de coupure basse est de 6 kHz.

Le procédé de filtrage utilisé par Scubapro est assez sommaire. Il n'est en effet pas difficile d'imaginer que de nombreux chocs, par exemple de l'instrument de plongée contre une pierre ou tout autre corps solide, vont induire une réponse en fréquence de l'accéléromètre comprise dans l'intervalle 6 kHz-25kHz, et donc provoquer un allumage intempestif des moyens d'éclairage du dispositif d'affichage.

La présente invention a pour but de remédier à ce problème ainsi qu'à d'autres encore en proposant un procédé de filtrage des signaux produits par un accéléromètre de type piézo-électrique en réponse à un choc qui permette de discriminer de façon plus fiable les chocs volontaires des chocs intempestifs non-voulus.

A cet effet, la présente invention concerne un procédé de filtrage des signaux produits par un accéléromètre de type piézo-électrique en réponse à la détection d'un choc appliqué sur un objet auquel l'accéléromètre est lié, ce procédé étant caractérisé en ce que l'on s'assure qu'au cours d'une première étape, le signal produit par l'accéléromètre, après avoir crû et dépassé une première valeur seuil, diminue et devient inférieur à une seconde valeur seuil inférieure à la première valeur seuil après une durée supérieure à un minimum et inférieure à un maximum.

Grâce à ces caractéristiques, la présente invention procure un procédé de filtrage des signaux produits par un accéléromètre piézo-électrique en réponse à la détection d'un choc qui permet de distinguer de façon fiable les chocs volontaires des chocs intempestifs. La présente invention trouve tout son intérêt dans son application à un objet portatif tel qu'un téléphone portable ou une pièce d'horlogerie. Dans le cas d'une pièce d'horlogerie, par exemple, la présente invention permet de faire une discrimination entre un choc volontaire appliqué sur la glace au moyen d'un doigt et les chocs involontaires correspondant, par exemple, au cas où la montre heurte un objet solide tel qu'une table ou au cas où le porteur de la montre applaudit. En procurant un procédé de filtrage aussi précis, la présente invention permet d'éviter qu'une fonction, par exemple l'allumage des moyens d'éclairage du dispositif d'affichage de grandeurs temporelles de la montre, ne se déclenche intempestivement, ce qui permet de réaliser des économies d'énergie considérables et de prolonger la durée de vie de la source d'énergie, par exemple une pile ou un accumulateur rechargeable, qui alimente la montre en courant.

Selon une caractéristique complémentaire du procédé, on s'assure au cours d'une seconde étape succédant à la première que le signal produit par l'accéléromètre reste inférieur à la première valeur seuil pendant une durée égale à une troisième valeur prédéterminée.

La présente invention concerne également un dispositif pour le filtrage des signaux produits par un accéléromètre de type piézo-électrique en réponse à la détection d'un choc appliqué sur un objet auquel l'accéléromètre est lié, ce dispositif étant caractérisé en ce qu'il comprend :
- des moyens de comparaison pour comparer le niveau du signal produit par l'accéléromètre à un premier et un second niveaux seuils ;
- des moyens d'enclenchement d'une base de temps qui est mise en fonction quand le niveau du signal de l'accéléromètre fourni aux moyens de comparaison est supérieur au premier niveau seuil ;
- un générateur de durées de référence commandé par la base de temps, et
- des moyens de contrôle dans le temps du niveau de sortie des moyens de comparaison par rapport aux durées de référence fournies par le générateur pour déterminer si le choc appliqué sur l'objet était volontaire ou non.

La présente invention concerne enfin un objet portatif tel qu'une pièce d'horlogerie comprenant un dispositif de filtrage du genre susdécrit, caractérisé en ce que, si les moyens de contrôle déterminent que le choc appliqué sur l'objet est volontaire, ils produisent un signal de commande pour la mise en marche d'une fonction de l'objet portatif.

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement, en liaison avec le dessin annexé sur lequel :
- la figure 1 est un diagramme d'états du circuit de détection ;
- les figures 2a à 2d représentent, en fonction du temps, l'aspect caractéristique des signaux produits par l'accéléromètre selon la nature du choc appliqué sur l'objet, et
- la figure 3 est un schéma bloc du circuit de détection.

La présente invention procède de l'idée générale inventive consistant à procurer un procédé de filtrage des signaux produits par un accéléromètre de type piézo-électrique en réponse à un choc exercé sur un objet auquel est associé l'accéléromètre qui permette de discriminer de façon fiable les chocs volontaires des chocs intempestifs non voulus. Dans le cas où un choc valide est détecté, le circuit pour la mise en oeuvre du présent procédé va produire un signal pour la commande d'une fonction électrique ou électronique de l'objet. Il peut s'agir, par exemple dans le cas où l'objet est une montre, de commander l'allumage des moyens d'éclairage du dispositif d'affichage de l'heure en appliquant un choc sur la glace de la montre au moyen d'un doigt. Ainsi, en évitant l'allumage intempestif des moyens d'éclairage, le procédé selon l'invention permet de réaliser des gains substantiels en termes de consommation électrique, ce qui permet d'augmenter la durée de vie de la source d'énergie, classiquement une pile ou un accumulateur rechargeable, qui alimente l'objet.

La présente invention va être décrite en liaison avec une pièce d'horlogerie du type montre-bracelet. Il va de soi que cet exemple est donné à titre purement illustratif seulement et que l'invention peut s'appliquer à tout type d'objet muni d'une fonction électrique ou électronique tel que, notamment, un téléphone portable.

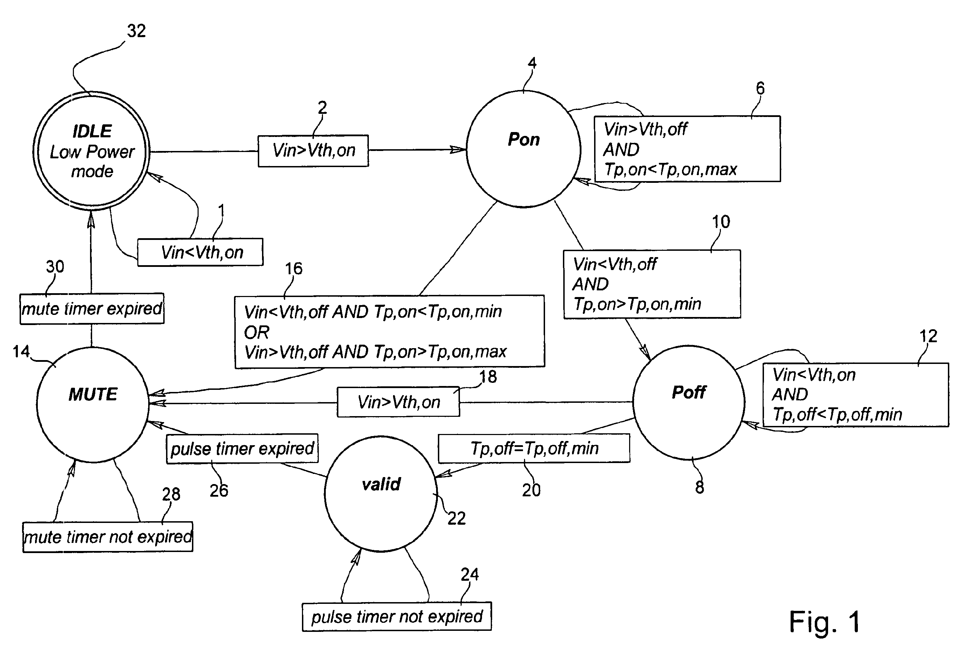

On se réfère tout d'abord à la figure 1 qui est un diagramme d'états du circuit de détection. Aussi longtemps que la tension V_{IN} aux bornes de l'accéléromètre piézo-électrique reste inférieure à une première valeur seuil V_{TH,ON}, le système est au repos (étape 1). En 2, une force d'impact telle a été appliquée sur l'objet que la tension V_{IN} aux bornes de l'accéléromètre devient supérieure à la valeur seuil V_{TH,ON}. Le système entre alors dans le mode actif P_{ON} illustré en 4.

Après avoir crû, la tension V_{IN} commence à décroître. En 6, on a représenté une condition de maintien du circuit de détection dans son mode actif 4. Cette condition de maintien est définie par deux critères qui doivent être vérifiés simultanément. Ces critères imposent à la tension V_{IN} de rester supérieure à une seconde valeur seuil V_{TH,OFF} inférieure à la première valeur seuil V_{TH,ON} pendant une durée T_{P,ON} inférieure à une valeur maximum T_{P,ON,MAX}. Aussitôt que l'une de ces deux conditions n'est plus remplie, le circuit de détection va transiter soit vers un état muet, soit vers un second mode actif comme décrit en détail ci-après.

La tension V_{IN} aux bornes de l'accéléromètre continuant de décroître, supposons qu'elle devienne inférieure à la valeur seuil V_{TH,OFF}. Le circuit de détection peut alors transiter vers le second mode actif P_{OFF} illustré en 8 sous réserve de vérifier la condition de transition 10 qui impose à la tension V_{IN} de rester inférieure à la valeur seuil V_{TH,OFF} pendant une durée minimum T_{P,ON} supérieure à une valeur T_{P,ON,MIN} elle-même inférieure à la durée T_{P,ON,MAX}.

En 12, on a représenté une seconde condition de maintien du circuit de détection dans son mode actif 8. Cette condition de maintien impose à la tension V_{IN} de ne pas présenter de rebond et de rester inférieure à la première valeur seuil V_{TH,ON} pendant une durée T_{P,OFF} au moins égale à une troisième valeur seuil T_{P,OFF,MIN}.

Si l'une des deux conditions énoncées en 6 n'est pas vérifiée, le système peut entrer dans un mode muet représenté en 14 dans lequel il n'accepte pas de nouveau choc. En effet, comme indiqué en 16, si la tension V_{IN} aux bornes de l'accéléromètre piézo-électrique est supérieure à V_{TH,OFF} mais pendant une durée T_{P,ON} inférieure à la durée T_{P,ON,MIN} ou si la tension V_{IN} est supérieure à V_{TH,OFF} mais pendant une durée T_{P,ON} supérieure à la valeur T_{P,ON,MAX}, le choc appliqué sur l'objet n'est pas reconnu comme valide.

Si, alors que le système se trouve dans le mode actif P_{OFF} représenté en 8, la tension V_{IN} aux bornes de l'accéléromètre présente un rebond qui lui fait dépasser la tension seuil V_{TH,ON} comme indiqué en 18 après un temps T_{P,OFF} inférieur à T_{P,OFF,MIN}, le système entre directement dans le mode muet en 14 dans lequel il n'accepte pas de nouveau choc. Cette disposition a notamment comme intérêt qu'elle évite au système de considérer comme correspondant à un choc valide la fin d'une série de rebonds de la tension V_{IN}. En effet, dans le cas du choc d'une montre contre une surface dure comme une table par exemple, le premier rebond de la tension V_{IN} pourrait être écarté par le système comme ne correspondant pas à un choc valide, mais le rebond suivant pourrait par contre remplir les conditions requises et être accepté par le système comme correspondant à un choc valide. Ainsi, la sortie du système deviendrait active alors que le choc initial était involontaire.

Au contraire, si la tension V_{IN} reste inférieure à la tension seuil V_{TH,ON} pendant une durée T_{P,OFF} au moins égale à la valeur T_{P,OFF,MIN} comme montré en 20, alors le choc appliqué sur l'objet est reconnu comme volontaire et le système entre dans le mode de validation comme indiqué en 22. Dans ce mode, la sortie du système devient active et le reste jusqu'à ce qu'un délai de temporisation indiqué en 24 soit arrivé à expiration. Il va de soi que pendant la durée durant laquelle la sortie du système reste active, ledit système n'accepte pas de nouveau choc. Lorsque la sortie du système redevient inactive après expiration du délai de temporisation comme indiqué en 26, le système entre dans le mode muet 14 et reste dans ce mode jusqu'à ce qu'un délai de temporisation indiqué en 28 soit arrivé à expiration. Lorsque le délai de temporisation arrive à expiration (étape 30), le système revient dans son état de repos (étape 32), prêt à détecter un nouveau choc.

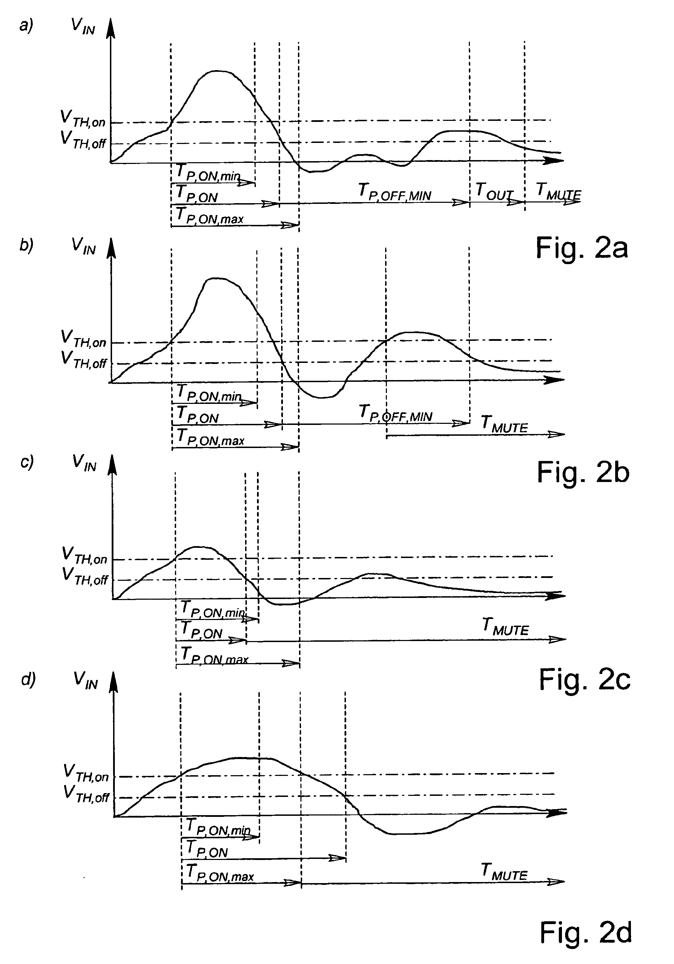

Les figures 2a à 2d représentent, en fonction du temps, l'aspect caractéristique des signaux produits par l'accéléromètre piézo-électrique selon la nature du choc appliqué sur l'objet.

La figure 2a correspond à un choc valide. La tension V_{IN} aux bornes de l'accéléromètre commence par dépasser la valeur seuil V_{TH,ON}. Après avoir crû et être passée par un maximum, la tension V_{IN} commence à décroître. Elle devient inférieure à la valeur seuil V_{TH,OFF} après une durée T_{P,ON} inférieure à la valeur T_{P,ON,MAX} et supérieure à la valeur T_{P,ON,MIN}. Par la suite, la tension V_{IN} aux bornes de l'accéléromètre ne présente pas de rebond et reste inférieure à la valeur seuil V_{TH,ON} pendant une durée T_{P,OFF} qui va au moins égaler la valeur T_{P,OFF,MIN}. Le choc étant reconnu comme valide, la sortie du système devient active pendant une durée T_{OUT}. Lorsque la sortie du système redevient inactive, le système entre dans un mode muet pendant un temps T_{MUTE} durant lequel ledit système n'accepte pas de nouveau choc.

La figure 2b correspond à un choc non-valide typiquement produit par un contact de l'objet contre une surface dure. On voit à l'examen de la figure 2b que la tension V_{IN} commence par présenter un profil satisfaisant comme à la figure 2a jusqu'à ce que, ayant décru en deçà de la valeur seuil V_{TH,OFF} elle ne recommence à croître et à dépasser à nouveau la valeur seuil V_{TH,ON} au bout d'une durée T_{P,OFF} inférieure à la valeur T_{P,OFF,MIN}. Aussitôt que la tension V_{IN} présente un rebond et dépasse pour la seconde fois la valeur seuil V_{TH,ON,} le système entre dans son mode muet dans lequel il n'accepte aucun nouveau choc pendant une durée T_{MUTE}.

La figure 2c correspond à un autre choc non-valide parce que trop faible. En effet, si la tension V_{IN} aux bornes de l'accéléromètre commence par dépasser la valeur seuil V_{TH,ON}, elle décroît rapidement et devient inférieure à la seconde valeur seuil après une durée T_{P,ON} qui est inférieure à T_{P,ON,MIN}, ce qui n'est pas suffisant. Le signal n'est donc pas reconnu comme valide et est rejeté par le système qui entre dans un mode muet dans lequel il n'accepte pas de nouveau choc pendant une durée T_{MUTE}.

Enfin, la figure 2d correspond également à un choc non-valide typiquement produit par un contact de l'objet contre une surface souple ou lorsque l'utilisateur applaudit dans le cas où l'objet est une montre-bracelet. On constate en effet à l'examen de la figure 2d qu'après avoir dépassé la valeur seuil V_{TH,ON}, la tension V_{IN} reste supérieure à la seconde valeur seuil V_{TH, OFF} pendant une durée T_{P,ON} supérieure à la valeur T_{P,ON.MAX}. Le signal n'est donc pas reconnu comme valide et est rejeté par le système qui entre dans le mode muet dans lequel il n'accepte aucun nouveau choc pendant une durée T_{MUTE}.

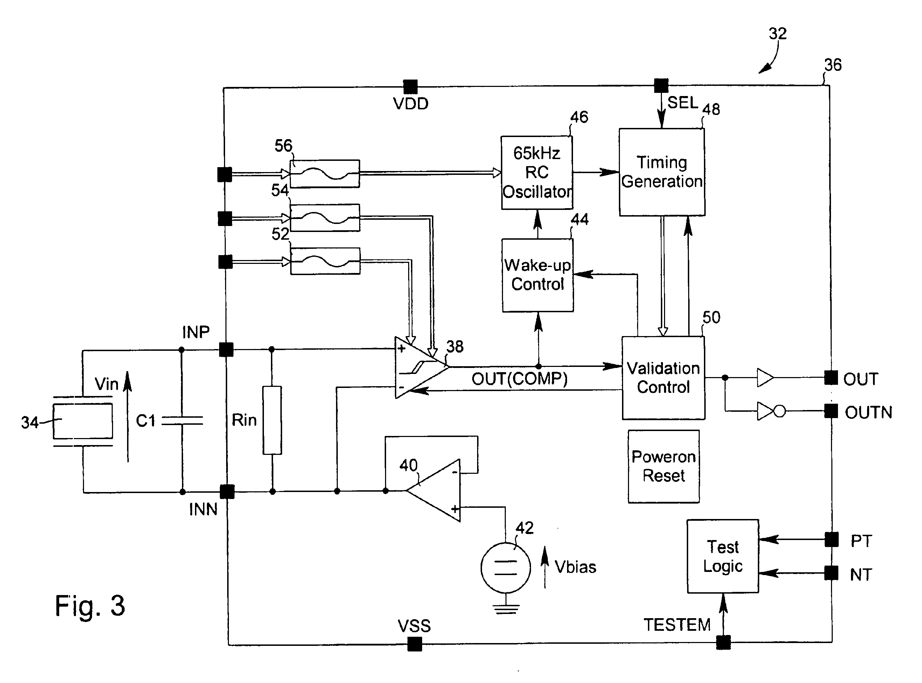

La figure 3 est un schéma bloc du circuit de détection. Désigné dans son ensemble par la référence numérique générale 32, ce circuit comprend un accéléromètre de type piézo-électrique 34 commercialisé par la société Murata sous la référence PKGS 90LC. Sous l'effet d'un choc, cet accéléromètre produit un courant qui est transformé en un signal de tension V_{IN} par sa propre capacité. Un condensateur C1 est monté en parallèle aux bornes de cet accéléromètre. Ce condensateur C1 qui peut prendre différentes valeurs est monté à l'extérieur d'un circuit intégré 36 et permet au circuit de détection 32 de voir toujours le même signal indépendamment de l'application à laquelle ledit circuit de détection 32 est destiné. Par exemple, dans le cas d'une application horlogère, le circuit de détection 32 verra un même signal que le boîtier de la montre soit en plastique ou métallique. Une résistance R_{IN} est également montée en parallèle aux bornes de l'accéléromètre 34 mais fait partie du circuit intégré 36. Cette résistance est destinée à permettre qu'au repos, l'entrée positive d'un comparateur 38 soit portée au même potentiel que son entrée négative. Un circuit suiveur 40 dont l'entrée positive est reliée à une source de tension de référence 42 génère une tension comprise entre les potentiels d'alimentation négatif et positif, respectivement V_{SS} et V_{DD}, du circuit intégré 36, tension dont on se sert pour polariser l'une des bornes de l'accéléromètre 34 et l'entrée négative du comparateur 38 et dont la valeur sera préférentiellement mais non limitativement fixée au voisinage de 700mV.

Le comparateur 38 est un comparateur à hystérésis présentant deux valeurs seuils respectivement V_{TH,OFF} et V_{TH,ON}. Selon l'étape du procédé de filtrage où l'on se trouve, la tension V_{IN} aux bornes de l'accéléromètre 34 sera comparée à l'une ou l'autre de ces deux valeurs seuils. La valeur seuil V_{TH, OFF} correspond préférentiellement à une différence de potentiel entre les bornes d'entrée du comparateur 38 de l'ordre de 0V +/- 5mV, tandis que la valeur seuil V_{TH,ON} peut être fixée au voisinage de 30mV +/- 2mV.

Supposons que le niveau du signal V_{IN} fourni par l'accéléromètre 34 au comparateur 38 soit supérieur au premier niveau seuil V_{TH,ON} juste après la détection d'un choc. Dans ce cas, le choc est considéré comme a priori valide et la sortie OUT(COMP) du comparateur 38 passe à un niveau haut. En réponse à ce signal, un circuit de mise en marche 44 commande l'enclenchement d'une base de temps 46 qui comprend un oscillateur RC dont la fréquence d'horloge est fixée à 65 kHz. Cette base de temps 46 fournit un signal d'horloge à un générateur de durées 48, autrement dit une chaîne de division qui décompte le temps et permet de s'assurer que la durée de l'impulsion V_{IN} produite par l'accéléromètre 34 est inférieure à une durée maximum T_{P,ON,MAX} et supérieure à une durée minimum T_{P,ON,MIN}. Les durées minimum T_{P,ON,MIN} et maximum T_{P,ON,MAX} ont pour valeurs respectives 0,488ms et 5,127ms. Le générateur de durées 48 permet également de générer la durée T_{P,OFF} pendant laquelle l'impulsion V_{IN} produite par l'accéléromètre 34 doit rester inférieure à la valeur seuil V_{TH,ON} pour que le signal soit reconnu comme valide. En pratique, lorsque le signal V_{IN} a dépassé la tension seuil V_{TH,ON}, le niveau de seuil du comparateur sera fixé à V_{TH, OFF} et inversement. La durée T_{P,OFF} a comme valeur 5,127ms. Par ailleurs, la durée T_{MUTE} durant laquelle le système n'accepte pas de nouveau choc est fixée à 46,8ms.

Enfin, un circuit de contrôle 50 vérifie si l'impulsion V_{IN} est valide selon le procédé illustré en liaison avec la figure 1. Si tel est le cas, sa sortie OUT passe à un niveau haut pendant une durée T_{OUT} déterminée par le générateur de durées 48. T_{OUT} détermine donc la durée pendant laquelle une fonction reste activée ou pendant laquelle la sortie numérique du circuit de contrôle 50 reste appliquée à une entrée d'un microcontrôleur. Passé ce délai, la sortie du circuit de contrôle 50 revient à un niveau bas inactif et le système reste insensible aux chocs pendant une durée supplémentaire T_{MUTE} déterminée par le générateur de durées 48. Si le choc n'est pas reconnu comme valide, le système passe immédiatement dans son état muet pendant la durée T_{MUTE}. On notera également que le circuit de contrôle 50 a aussi pour fonction d'indiquer au comparateur 38 lequel de ses deux niveaux haut ou bas V_{TH,ON} ou V_{TH,OFF} il doit comparer à la tension V_{IN} présente aux bornes de l'accéléromètre 34.

Finalement, on prévoit des fusibles 52, 54 et 56 qui, pour un circuit intégré donné, permettent d'ajuster les seuils V_{TH,OFF}, V_{TH,ON} et la fréquence du circuit d'horloge 46.

Il va de soi que la présente invention n'est pas limitée au mode de mise en oeuvre qui vient d'être décrit, et que diverses modifications et variantes simples peuvent être envisagées par l'homme du métier sans sortir du cadre de la présente invention.

## Revendications

1. Procédé de filtrage des signaux (V_{IN}) produits par un accéléromètre (34) de type piézo-électrique en réponse à la détection d'un choc appliqué sur un objet auquel l'accéléromètre est lié, ce procédé étant **caractérisé en ce que** l'on s'assure qu'au cours d'une première étape, le signal (V_{IN}) produit par l'accéléromètre (34), après avoir crû et dépassé une première valeur seuil (V_{TH,ON}), diminue et devient inférieur à une seconde valeur seuil (V_{TH,OFF}) inférieure à la première valeur seuil (V_{TH,ON}) après une durée (T_{P,ON}) supérieure à une durée minimum (T_{P.ON,MIN}) et inférieure à une durée maximum (T_{P,ON,MAX}).

2. Procédé selon la revendication 1, **caractérisé en ce que** l'on s'assure au cours d'une seconde étape succédant à la première étape que le signal (V_{IN}) produit par l'accéléromètre (34) reste inférieur à la première valeur seuil (V_{TH,ON}) pendant une durée au moins égale à une troisième valeur prédéterminée (T_{P.OFF.MIN}).

3. Procédé selon l'une quelconque des revendications 1 ou 2, **caractérisé en ce que**, si le signal (V_{IN}) produit par l'accéléromètre (34) reste supérieur à la seconde valeur seuil (V_{TH.OFF}) après une durée (T_{P.ON}) inférieure à la durée minimum (T_{P.ON.MIN}), ou si le signal (V_{IN}) reste supérieur à la seconde valeur seuil (V_{TH.OFF}) mais pendant une durée (T_{P.ON}) supérieure à la durée maximum (T_{P.ON.MAX}), on ne reconnaît pas le choc comme valide.

4. Procédé selon l'une quelconque des revendications 2 ou 3, **caractérisé en ce que** si le signal (V_{IN}), après la première étape, redevient supérieur à la première valeur seuil (V_{TH,ON}) au bout d'un temps inférieur à la durée (T_{P},_{OFF.MIN}), le choc n'est pas reconnu comme valide.

5. Dispositif pour le filtrage des signaux (V_{IN}) produits par un accéléromètre (34) de type piézo-électrique en réponse à la détection d'un choc appliqué sur un objet auquel l'accéléromètre (34) est lié, ce dispositif étant **caractérisé en ce qu'**il comprend :
- des moyens de comparaison (38) pour comparer le niveau du signal (V_{IN}) produit par l'accéléromètre (34) à un premier et un second niveaux seuils (V_{TH,ON} ; V_{TH,OFF}) :
- des moyens d'enclenchement (44) d'une base de temps (46) qui est mise en fonction lorsque le niveau du signal (V_{IN}) de l'accéléromètre (34) fourni aux moyens de comparaison (38) est supérieur au premier niveau seuil (V_{TH,ON}) ;
- un générateur de durées de référence (48) commandé par la base de temps (46), et
- des moyens de contrôle (50) dans le temps du niveau de sortie (OUT(COMP)) des moyens de comparaison par rapport aux durées de référence fournies par le générateur (48) pour déterminer si le choc est valide ou non.

6. Dispositif selon la revendication 5, **caractérisé en ce que** le générateur de durées de référence (48) génère les durées suivantes :
- une durée minimum (T_{P,ON,MIN}) et une durée maximum (T_{P,ON,MAX}) entre lesquelles doit être comprise une durée (T_{P,ON}) après laquelle le signal (V_{IN}) devient inférieur à une seconde valeur seuil (V_{TH,OFF}) après avoir excédé la première valeur seuil (V_{TH,ON});
- une troisième valeur prédéterminée (T_{P,OFF,MIN)} durant laquelle le signal (V_{IN}) ne doit pas à nouveau excéder la première valeur seuil (V_{TH.ON});
- une première durée de temporisation (T_{OUT}) pendant laquelle une fonction reste activée ou pendant laquelle une sorte numérique du circuit de contrôle (50) reste appliquée à une entrée d'un microcontrôleur, et
- une seconde durée de temporisation (T_{MUTE}) durant laquelle le dispositif de filtrage (32) n'accepte aucun nouveau choc.

7. Dispositif selon la revendication 6, **caractérisé en ce que** :
- la durée (T_{P,ON,MIN}) a pour valeur 0,488ms;
- la durée (T_{P,ON,MAX}) a pour valeur 5,127ms;
- la durée (T_{P,OFF,MIN}) a pour valeur 5,127ms, et
- la durée (T_{OUT}) a pour valeur 46,8ms.

8. Dispositif selon l'une quelconque des revendications 5 à 7, **caractérisé en ce qu'**il comprend un circuit intégré (36).

9. Dispositif selon la revendication 8, **caractérisé en ce qu'**un condensateur (C1) est monté en parallèle aux bornes de l'accéléromètre (34) à l'extérieur du circuit intégré (36) de façon que les moyens de comparaison (38) voient toujours le même signal indépendamment de l'application à laquelle le dispositif de filtrage (32) est destiné.

10. Dispositif selon l'une quelconque des revendications 5 à 9, **caractérisé en ce que** les moyens de comparaison (38) comprennent un comparateur à hystérésis présentant deux valeurs seuils, respectivement (V_{TH,OFF}) et V_{TH,ON}).

11. Dispositif selon la revendication 10, **caractérisé en ce qu'**une résistance (R_{IN}) est montée en parallèle aux bornes du comparateur (38), de façon à permettre que lorsque le dispositif de filtrage (32) est au repos, les bornes du comparateur (38) soient au, même potentiel.

12. Dispositif selon l'une quelconque des revendications 5 à 11, **caractérisé en ce que** la base de temps (46) comprend un oscillateur RC.

13. Dispositif selon la revendication 12, **caractérisé en ce que** la fréquence d'horloge de l'oscillateur RC est fixée à 65 kHz.

14. Dispositif selon l'une quelconque des revendications 5 à 13, **caractérisé en ce que** le générateur de durées (48) comprend une chaîne de division qui décompte le temps.

15. Dispositif selon l'une quelconque des revendications 5 à 14, **caractérisé en ce que** les moyens de contrôle (50) ont également pour fonction d'indiquer aux moyens de comparaison (38) lequel des deux niveaux haut ou bas (V_{TH,ON}; V_{TH,OFF}) doit être comparé à la tension (V_{IN}) produite par l'accéléromètre (34).

16. Dispositif selon l'une quelconque des revendications 5 à 15, **caractérisé en ce qu'**il comprend des fusibles (52, 54, 56) qui permettent d'ajuster les seuils (V_{TN,OFF} ; V_{TH.ON}) et la fréquence d'horloge de la base de temps (46).

17. Dispositif selon l'une quelconque des revendications 7 à 16, **caractérisé en ce qu'**il comprend un circuit suiveur (40) relié, à une source de tension de référence (42) et qui génère une tension comprise entre les potentiels d'alimentation négatif et positif (V_{SS}) et (V_{DD}) du circuit intégré (36), tension dont on se sert pour polariser l'une des bornes de l'accéléromètre (34) et du comparateur (38).

18. Dispositif selon la revendication 17, **caractérisé en ce que** la tension générée par le circuit suiveur (40) est fixée au voisinage de 700mV.

19. Dispositif selon l'une quelconque des revendications 5 à 18, **caractérisé en ce que** la valeur seuil (V_{TH,OFF}) correspond à une différence de potentiel de l'ordre de 0V +/- mV, et **en ce que** la valeur seuil (V_{TH,CN}) peut être fixée au voisinage de 30 mV +/- 2mV.

20. Objet portatif tel qu'une montre-bracelet comprenant un dispositif de filtrage selon l'une quelconque des revendications 5 à 19, **caractérisé en ce que**, si les moyens de contrôle déterminent qu'au cours d'une première étape, le signal (V_{IN}) produit par l'accéléromètre (34), après avoir crû et dépassé une première valeur seuil (V_{TH,ON}), diminue et devient inférieur à une seconde valeur seuil (V_{TH,OFF}) inférieure à la première valeur seuil (V_{TH,ON}) après une durée (T_{P,ON}) supérieure à une durée minimum (T_{P,ON,MIN}) et inférieure à une durée maximum (T_{P,ON,MAX}), ils concluent que le choc appliqué sur l'objet est volontaire et produisent un signal de commande pour la mise en marche d'une fonction de l'objet portatif.

## Patentansprüche

1. Verfahren zum Filtern von Signalen (von), die durch einen Beschleunigungsmesser (34) des piezoelektrischen Typs in Reaktion auf die Detektion eines Stoßes, der auf ein Objekt ausgeübt wird, mit dem der Beschleunigungsmesser verbunden ist, erzeugt werden, wobei dieses Verfahren **dadurch gekennzeichnet ist, dass** sichergestellt ist, dass während eines ersten Schrittes das Signal (V_{IN}), das durch den Beschleunigungsmesser (34) erzeugt wird, nachdem es angewachsen ist und einen ersten Schwellenwert (V_{TH,ON}) durchläuft, nach einer Dauer (T_{P,ON}), die größer als eine minimale Dauer (T _{P,ON,MIN}) und kleiner als eine maximale Dauer (T_{P,ON,MAX}) ist, abnimmt und kleiner als ein zweiter Schwellenwert (V_{TH,OFF}), der kleiner als der erste Schwellenwert (V_{TH,ON}) ist, wird.

2. Verfahren nach Anspruch 1, **dadurch gekennzeichnet, dass** während eines zweiten Schrittes, der auf den ersten Schritt folgt, sichergestellt ist, dass das von dem Beschleunigungsmesser (34) erzeugte Signal (V_{IN}) während einer Dauer, die wenigstens gleich einem dritten vorgegebenen Wert (T_{P,OFF,MIN}) ist, kleiner als der erste Schwellenwert (V_{TH,ON}) bleibt.

3. Verfahren nach einem der Ansprüche 1 oder 2, **dadurch gekennzeichnet, dass** dann, wenn das von dem Beschleunigungsmesser (34) erzeugte Signal (V_{IN}) nach einer Dauer (T_{P,ON}), die kleiner als die minimale Dauer (T_{P,ON,MIN}) ist, größer als der zweite Schwellenwert (V_{TH,OFF}) bleibt, oder wenn das Signal (V_{IN}) größer als der zweite Schwellenwert (V_{TH,OFF}) bleibt, dies jedoch während einer Dauer (T_{P,ON}), die größer als die maximale Dauer (T_{P,ON,MAX}) ist, der Stoß nicht als gültig erkannt wird.

4. Verfahren nach einem der vorhergehenden Ansprüche 2 oder 3, **dadurch gekennzeichnet, dass** dann, wenn das Signal (V_{IN}) nach dem ersten Schritt am Ende einer Zeit, die kleiner als die Dauer (T_{P,OFF,MIN}) ist, wieder größer als der erste Schwellenwert (V_{TH,ON}) wird, der Stoß nicht als gültig erkannt wird.

5. Vorrichtung zum Filtern von Signalen (V_{IN}), die von einem Beschleunigungsmesser (34) des piezoelektrischen Typs in Reaktion auf die Detektion eines Stoßes, der auf ein Objekt, mit dem der Beschleunigungsmesser (34) verbunden ist, ausgeübt wird, erzeugt werden, wobei diese Vorrichtung **dadurch gekennzeichnet ist, dass** sie umfasst:
- Vergleichsmittel (38), um den Pegel des von dem Beschleunigungsmesser (34) erzeugten Signals (V_{IN}) mit einem ersten und einem zweiten Schwellenwert (V_{TH,ON}; V_{TH,OFF}) zu vergleichen;
Mittel (44) zum Auslösen einer Zeitbasis (46), die in Betrieb versetzt wird, wenn der Pegel des an die Vergleichsmittel (38) gelieferten Signals (V_{IN}) des Beschleunigungsmessers (34) größer als der erste Schwellenpegel (V_{TH,ON}) ist;
- einen Referenzdauer-Generator (48), der durch die Zeitbasis (46) gesteuert wird, und
- Mittel (50) zum zeitlichen Steuern des Ausgangspegels (OUT(COMP)) der Vergleichsmittel in Bezug auf die Referenzdauern, die von dem Generator (48) geliefert werden, um zu bestimmen, ob der Stoß gültig ist oder nicht.

6. Vorrichtung nach Anspruch 5, **dadurch gekennzeichnet, dass** der Referenzdauer-Generator (48) die folgenden Dauern erzeugt:
- eine minimale Dauer (T_{P,ON,MIN}) und eine maximale Dauer (T_{P,ON,MAX}), zwischen denen eine Dauer (T_{P,ON}) enthalten ist, nach der das Signal (V_{IN}) kleiner als ein zweiter Schwellenwert (V_{TH,OFF}) wird, nachdem es den ersten Schwellenwert (V_{TH,ON}) überschritten hat;
- einen dritten vorgegebenen Wert (T_{P,OFF,MIN}), währenddessen das Signal (V_{IN}) den ersten Schwellenwert (V_{TH,ON}) nicht erneut überschreiten darf;
- eine erste Verzögerungsdauer (T_{OUT}), während der eine Funktion aktiv bleibt oder während der ein digitaler Anteil der Steuerschaltung (50) an einen Eingang eines Mikrocontrollers angelegt bleibt, und
- eine zweite Verzögerungsdauer (T_{MUTE}), während der die Filterungsvorrichtung (32) keinen neuen Stoß akzeptiert.

7. Vorrichtung nach Anspruch 6, **dadurch gekennzeichnet, dass**:
- die Dauer (T_{P,ON,MIN}) als Wert 0,488 ms hat;
- die Dauer (T_{P,ON,MAX}) als Wert 5,127 ms hat;
- die Dauer (T_{P,OFF,MIN}) als Wert 5,127 ms hat und
- die Dauer (T_{OUT}) als Wert 46,8 ms hat.

8. Vorrichtung nach einem der Ansprüche 5 bis 7, **dadurch gekennzeichnet, dass** sie eine integrierte Schaltung (36) umfasst.

9. Vorrichtung nach Anspruch 8, **dadurch gekennzeichnet, dass** ein Kondensator (C1) zu den Anschlüssen des Beschleunigungsmessers (34) außerhalb der integrierten Schaltung (36) parallelgeschaltet ist, derart, dass die Vergleichsmittel (38) unabhängig von der Eingabe, für die die Filterungsvorrichtung (32) bestimmt ist, stets das gleiche Signal sehen.

10. Vorrichtung nach einem der Ansprüche 5 bis 9, **dadurch gekennzeichnet, dass** die Vergleichsmittel (38) einen Komparator mit Hysterese umfassen, der zwei Schwellenwerte (V_{TH,OFF} bzw. V_{TH,ON}) aufweist.

11. Vorrichtung nach Anspruch 10, **dadurch gekennzeichnet, dass** ein Widerstand (R_{IN}) zu den Anschlüssen des Komparators (38) parallelgeschaltet ist, derart, dass es möglich ist, dann, wenn die Filterungsschaltung (32) in Ruhe ist, die Anschlüsse des Komparators (38) auf demselben Potential liegen.

12. Vorrichtung nach einem der Ansprüche 5 bis 11, **dadurch gekennzeichnet, dass** die Zeitbasis (46) einen RC-Oszillator enthält.

13. Vorrichtung nach Anspruch 12, **dadurch gekennzeichnet, dass** die Taktfrequenz des RC-Oszillators auf 65 kHz festgelegt ist.

14. Vorrichtung nach einem der Ansprüche 5 bis 13, **dadurch gekennzeichnet, dass** der Dauer-Generator (48) eine Teilungskette, die die Zeit abwärts zählt, umfasst.

15. Vorrichtung nach einem der Ansprüche 5 bis 14, **dadurch gekennzeichnet, dass** die Steuermittel (50) außerdem die Funktion haben, den Vergleichsmitteln (38) anzugeben, ob der Hochpegel oder der Tiefpegel (V_{TH,ON}; V_{TH,OFF}) mit der von der Beschleunigungsmesser (34) erzeugten Spannung (V_{IN}) verglichen werden soll.

16. Vorrichtung nach einem der Ansprüche 5 bis 15, **dadurch gekennzeichnet, dass** sie Schmelzsicherungen (52, 54, 56) umfasst, die ermöglichen, die Schwellenwerte (V_{TH,OF}; V_{TH,ON}) und die Taktfrequenz der Zeitbasis (46) einzustellen.

17. Vorrichtung nach einem der Ansprüche 7 bis 16, **dadurch gekennzeichnet, dass** sie eine Folgerschaltung (40) umfasst, die mit einer Referenzspannungsquelle (42) verbunden ist und eine Spannung erzeugt, die zwischen dem negativen und dem positiven Versorgungspotential (V_{SS} bzw. V_{DD}) der integrierten Schaltung (36) liegt, wobei einer der Anschlüsse des Beschleunigungsmessers (34) und des Komparators (38) mit der Spannung vorgespannt wird.

18. Vorrichtung nach Anspruch 17, **dadurch gekennzeichnet, dass** die von der Folgerschaltung (40) erzeugte Spannung in der Umgebung von 700 mV liegt.

19. Vorrichtung nach einem der Ansprüche 5 bis 18, **dadurch gekennzeichnet, dass** der Schwellenwert (V_{TH,OFF}) einer Potentialdifferenz in der Größenordnung von 0 V ± 5 mV entspricht und dass der Schwellenwert (V_{TH,ON}) in der Umgebung von 30 mV ± 2 mV festgelegt werden kann.

20. Tragbarer Gegenstand wie etwa eine Armbanduhr, der eine Filterungsvorrichtung nach einem der Ansprüche 5 bis 19 umfasst, **dadurch gekennzeichnet, dass** dann, wenn die Steuermittel bestimmen, dass während eines ersten Schrittes das Signal (V_{IN}), das von dem Beschleunigungsmesser (34) erzeugt wird, nachdem es angestiegen ist und einen ersten Schwellenwert (V_{TH,ON}) durchlaufen hat, nach einer Dauer (T_{P,ON}), die größer als eine minimale Dauer (T_{P,ON,MIN}) und kleiner als eine maximale Dauer (T_{P,ON,MAX}) ist, abnimmt und kleiner als ein zweiter Schwellenwert (V_{TH,OFF}), der kleiner als der erste Schwellenwert (V_{TH,ON}) ist, wird, der Schluss gezogen wird, dass der auf das Objekt ausgeübte Stoß absichtlich erfolgt, und ein Steuersignal erzeugt wird, um eine Funktion des tragbaren Gegenstands auszulösen.

## Claims

1. Method for filtering signals (V_{IN}) generated by a piezo-electric type accelerometer (34) in response to detection of a shock applied to an object to which the accelerometer is connected, this method being **characterised in that** it is ensured, during a first step, that the signal (V_{IN}) generated by the accelerometer (34), after having increased and exceeded a first threshold value (V_{TH,ON}) decreases and becomes lower than a second threshold value (V_{TH,OFF}) lower than the first threshold value (V_{TH,ON}) after a period of time (T_{P,ON}) greater than a minimum period of time (Tp_{,ON,MIN}) and less than a maximum period of time (T_{P,ON,MAX}):

2. Method according to claim 1, **characterised in that** it is ensured, during a second step following the first step, that the signal (V_{IN}) generated by the accelerometer (34) remains lower than the first threshold value (V_{TH,ON}) for a period of time that is at least equal to a third predetermined value (T_{P,OFF,MIN)}.

3. Method according to claims 1 or 2, **characterised in that**, if the signal (V_{IN}) generated by the accelerometer (34) remains higher than the second threshold value (V_{TH,OFF}) after a period of time (T_{P,ON}) less than the minimum period of time (T_{P,ON,MIN}), or if the signal (V_{IN}) remains higher than the second threshold value (V_{TH,OFF}), but for a period of time (T_{P,ON}) greater than the maximum period of time (T_{P,ON,MAX}), the shock is not recognised as valid.

4. Method according to claims 2 or 3, **characterised in that** if the signal (V_{IN}) after the first step, becomes higher than the first threshold value (V_{TH,ON}) again, after a time less than the period of time (T_{P,OFF,MIN}), the shock is not recognised as valid.

5. Device for filtering signals (V_{IN}) generated by a piezo-electric type accelerometer (34) in response to detection of a shock applied to an object to which the accelerometer (34) is connected, this device being **characterised in that** it includes:
- comparison means(38) for comparing the level of the signal (V_{IN}) generated by the accelerometer (34) to a first and a second threshold level (V_{TH,ON}; V_{TH,OFF});
- means for switching (44) on a time base (46), which is actuated when the level of the signal (V_{IN}) from the accelerometer (34) supplied to the comparison means (38) is higher than the first threshold level (V_{TH,ON});
- a generator of reference time periods (48) controlled by the time base (46), and
- means (50) for checking over time the output level (OUT(COMP)) of the comparison means in relation to the reference periods of time provided by the generator (48) to determine whether the shock applied to the object was valid or not.

6. Device according to claim 5, **characterised in that** the reference time period generator (48) generates the following period of times:
- a minimum period of time (T_{P,ON,MIN}) and a maximum period of time (T_{P,ON,MAX}) between which there must be comprised a period of time (T_{P,ON}) after which the signal (V_{IN}) becomes lower than a second threshold value (V_{TH,OFF}) after having exceeded the first threshold value (V_{TH,ON});
- a third predetermined value (T_{P,OFF,MIN}) during which the signal (V_{IN}) must not exceed the first threshold value (V_{TH,ON}) again;
- a first time delay (T_{OUT}) during which a function remains activated or during which a digital sort of checking circuit (50) remains applied to an input of a microcontroller, and
- a second time delay (T_{MUTE}) during which the filtering device (32) does not accept any new shocks.

7. Device according to claim 6, **characterised in that**:
- the period of time (T_{P,ON,MIN}) has a value of 0.488ms;
- the period of time (T_{P,ON,MAX}) has a value of 5.127ms;
- the period of time (T_{P,OFF,MIN}) has a value of 5.127ms, and
- the period of time (T_{OUT}) has a value of 46.8ms.

8. Device according to any of claims 5 to 7, **characterised in that** it includes an integrated circuit (36).

9. Device according to claim 8, **characterised in that** a capacitor (C1) is mounted in parallel across the terminals of the accelerometer (34) outside the integrated circuit (36) such that the comparison means (38) always see the same signal regardless of the application for which the filtering device (32) is intended.

10. Device according to any of claims 5 to 9, **characterised in that** the comparison means (38) include a hysteresis comparator having two threshold values, respectively (V_{TH,OFF}) and (V_{TH,ON}).

11. Device according to claim 10, **characterised in that** a resistor (R_{IN}) is mounted in parallel to the terminals of the comparator (38), so that, when the filtering device (32) is at rest, the terminals of the comparator (38) are at the same potential.

12. Device according to any of claims 5 to 11, **characterised in that** the time base (46) includes an RC oscillator.

13. Device according to claim 12, **characterised in that** the clock frequency of the RC oscillator is fixed at 65 kHz.

14. Device according to any of claims 5 to 13, **characterised in that** the time period generator (48) includes a chain division which counts down time.

15. Device according to any of claims 5 to 14, **characterised in that** it is also a function of the checking means (50) to indicate to the comparison means (38) which of the two high or low levels (V_{TH,ON}; V_{TH,OFF}) has to be compared to the voltage (V_{IN}) generated by the accelerometer (34).

16. Device according to any of claims 5 to 15, **characterised in that** it includes fuses (52, 54, 56) which allow the thresholds (V_{TH,OFF}; V_{TH,ON}) and the clock frequency of the time base (46) to be adjusted.

17. Device according to any of claims 7 to 16, **characterised in that in that** it includes a follower circuit (40) connected to a reference voltage source (42) which generates a voltage comprised between the negative and positive supply potentials (V_{SS}) and (V_{DD}) of the integrated circuit (36), said voltage being used to polarise one of the terminals of accelerometer (34) and of the comparator (38).

18. Device according to claim 17, **characterised in that** the voltage generated by the follower circuit (40) is fixed in proximity to 700mV.

19. Device according to any of claims 5 to 18, **characterised in that** the threshold value (V_{TH,OFF}) corresponds to a potential difference of the order of 0V+/-5mV, and **in that** the threshold value V_{TH,ON} can be fixed in proximity to 30 mV +/- 2mV.

20. Portable object such as a wristwatch including a filtering device according to any of claims 5 to 19, **characterised in that**, if the checking means determine that, during a first step, the signal (V_{IN}) generated by the accelerometer (34), after having increased and exceeded a first threshold value (V_{TH,ON}), decreases and becomes lower than a second threshold value (V_{TH,OFF}) lower than the first threshold value (V_{TH,ON}) after a period of time (T_{P,ON}) greater than a minimum period of time (T_{P,ON,MIN}) and less than a maximum period of time (T_{P,ON,MAX}), they conclude that the shock applied to the object is deliberate, and they generate a control signal for switching on a function of the portable object.
